# NOUVEAU FASCICULE DE BREVET EUROPEEN

(11) **EP 0 300 872 B2**
(45) Date de publication et mention de la décision concernant l'opposition: **15.05.1996**
(45) Mention de la délivrance du brevet: 09.12.1992
(21) Numéro de dépôt: 88401773.2
(22) Date de dépôt: 07.07.1988
(51) Int. Cl.: H01H 9/00, H02M 7/00, H05K 9/00, H03H 1/00

(54) **Dispositif de filtrage des perturbations de mode commun affectant les cartes électroniques d'un convertisseur statique de puissance**
Gleichtaktunterdrückungseinrichtung für elektronische Karten einer statischen Leistungsversorgungsvorrichtung
Filtering device for common types disturbances acting on a static power converter's electronic cards

(30) Priorité: 23.07.1987 FR 8710521
(43) Date de publication de la demande: 25.01.1989
(73) Titulaire: MERLIN GERIN, F-38050 Grenoble Cédex (FR)
(72) Inventeur: Fiorina, Jean-Noel, F-38050 Grenoble Cedex (FR); Denis, Hervé, F-38050 Grenoble Cedex (FR)
(74) Mandataire: Hecke, Gérard

(56) Documents cités:
- US-A- 4 259 705
- US-A- 4 636 752
- PATENT ABSTRACTS OF JAPAN, vol. 4, no. 4 (E-164), 12 janvier 1980, page 133 E 164; & JP-A-54 144 851 (MATSUSHITA DENKI SANGYO K.K.) 12-11-1979
- Prospectus de Siemens "Statische unterbrechungsfreie Stromversorgungsanlagen-Typenreihe 31", décembre 1983
- Prospectus de Siemens "Statische unterbrechungsfreie Stromversorgungsanlagen-Typenreihe 32", décembre 1983
- "Richtlinien für die Erstellung von Betriebsanleitungen", annexe 2 du RS SG-Nr.283 du 17.02.86
- Livre "Noise Reduction Techniques in Electronic Systems", de Henry W.Ott, John Wiley et fils, 1976
- Journal "JEE", juin 1981, pages 44 à 49

## Description

### DISPOSITIF DE FILTRAGE DES PERTURBATIONS DE MODE COMMUN AFFECTANT LES CARTES ELECTRONIQUES D'UN CONVERTISSEUR STATIQUE DE PUISSANCE

L'invention est relative à un convertisseur statique de puissance, notamment pour un système d'alimentation sans coupure, comprenant un circuit de conversion ayant une pluralité de semi-conducteurs de puissance, une carte électronique de commande des semi-conducteurs du circuit de conversion, et des moyens d'alimentation électrique de la carte électronique de commande.

Les problèmes rencontrés dans le fonctionnement d'un convertisseur statique concernent la transmission des informations de commande de l'électronique à bas niveau vers les semi-conducteurs de puissance du circuit de conversion, notamment les thyristors d'un chargeur de batterie, ou les transistors des mutateurs d'un onduleur. Les conducteurs véhiculant ces informations, subissent des perturbations de mode commun dues aux brusques variations de potentiel des semi-conducteurs qu'ils commandent, lorsque ces derniers deviennent conducteurs ou se bloquent. Ces perturbations peuvent affecter le fonctionnement des cartes électroniques de commande. Une solution pour minimiser l'influence de ces perturbations consiste à limiter la circulation du courant en insérant une bobine de compensation entre chaque semi-conducteur de puissance et les conducteurs de commande concernés de la carte électronique. L'inductance réalisée n'affecte pas la transmission des signaux utiles, mais s'oppose à la circulation des courants de même valeur instantanée sur deux fils.

Il existe dans le commerce, une gamme importante de bobines à compensation de courant ayant des caractéristiques différentes en intensités de courant et en impédances. Ces bobines se présentent sous forme de composants individuels ayant des pattes de raccordement qui doivent être soudées dans le circuit. Un circuit de conversion d'un convertisseur statique possède un certain nombre de semi-conducteurs de puissance, et la gamme d'un système d'alimentation sans coupure présente d'autre part différents niveaux de puissance (par exemple 10kVA, 20kVA...80kVA). A chaque puissance, et à chaque type de circuit de conversion, doit correspondre une impédance prédéterminée de la bobine de compensation. On remarque qu'une multitude de bobines de compensation seraient nécessaires pour obtenir une atténuation efficace des parasites engendrés par le fonctionnement du convertisseur. Le soudage individuel de ces bobines complique d'autre part la fabrication du convertisseur.

Il est également connu de constituer une inductance de mode commun au moyen de plusieurs fils conducteurs autour d'un circuit magnétique en forme de tore. Il en résulte un enroulement hélicoïdal réparti sur une portion de la surface du tore en fonction du nombre de spires.

L'objet de l'invention consiste à simplifier l'opération de déparasitage d'un convertisseur statique de puissance.

Le convertisseur selon l'invention est caractérisé en ce que la totalité des conducteurs de transmission d'informations de commande et de surveillance entre la carte de commande et le circuit de conversion est conformée en limande souple, dont la partie intermédiaire est enroulée sur un circuit magnétique unique pour constituer la bobine d'une inductance de mode commun, destinée à compenser les perturbations affectant la carte électronique, par l'action des variations de potentiel des semi-conducteurs engendrés lors du passage de l'état conducteur vers l'état bloqué, et vice-versa, que le circuit magnétique présente une structure rectangulaire ayant une noyau central sur lequel est enroulée la limande , et qu'un connecteur est connecté à chaque extrémité de la limande pour faciliter l'insertion de l'inductance de mode commun entre la carte électronique et le circuit de puissance correspondant.

A chaque carte de commande est associée une seule inductance de mode commun. Le circuit magnétique de l'inductance est standard pour toutes les puissances, la valeur de l'impédance étant ajustée par le nombre de spires de la limande. La réalisation et l'insertion de mode commun s'effectue sans opération de soudage.

Les semi-conducteurs de puissance du circuit de conversion comportent des transistors ou des thyristors ayant un couplage prédéterminé pour définir, soit des modules mutateur d'un onduleur, soit un module redresseur-chargeur, soit un module contacteur statique, ayant chacun respectivement une carte de commande appropriée et une inductance de mode commun.

D'autres avantages et caractéristiques ressortiront plus clairement de la description qui va suivre de plusieurs modes de réalisation de l'invention, donnés à titre d'exemples non limitatifs et représentés aux dessins annexés dans lesquels :
La figure 1 représente le schéma d'un onduleur triphasé équipé de l'inductance de mode commun selon l'invention.
La figure 2 montre l'insertion de l'inductance de mode commun dans les commandes d'un redresseur-chargeur.
La figure 3 représente une variante appliquée à un contacteur statique.
La figure 4 représente une vue à échelle agrandie de l'inductance de mode commun utilisée dans le circuit de la figure 1.
La figure 5 est une variante de la figure 4, d'une inductance de mode commun utilisée dans les circuits des figures 2 et 3.
La figure 6 montre l'insertion d'une inductance de mode commun dans le circuit d'alimentation du convertisseur;
- la figure 7 illustre l'implantation des différentes inductances de mode commun dans un système d'alimentation sans coupure.

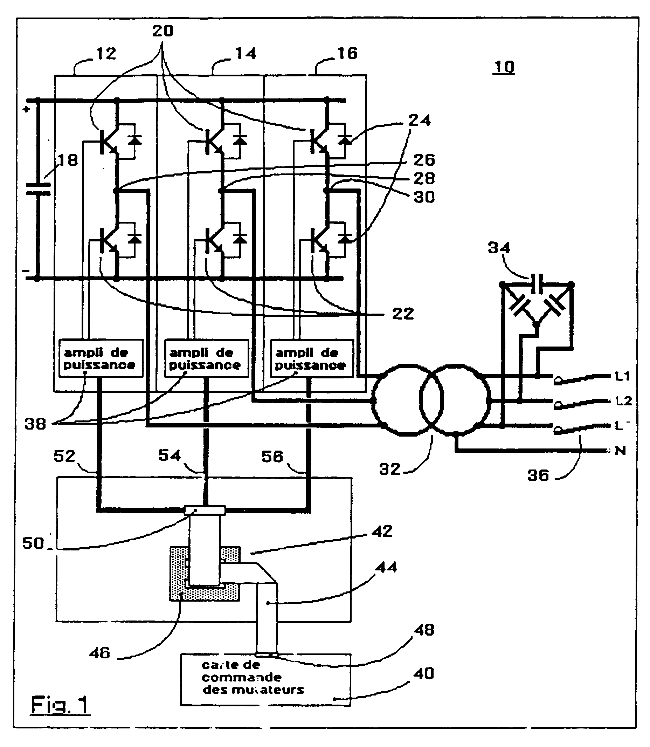

En référence à la figure 1, un onduleur 10 triphasé comporte trois modules mutateurs 12,14,16 ayant des structures identiques, avec couplage en parallèle aux bornes d'un condensateur 18, et d'une source à courant continu. Chaque mutateur 12,14,16 comporte deux transistors de puissance 20,22 branchés en série, le collecteur du transistor 20 étant relié électriquement au pôle positif de la source à courant continu, et l'émetteur du transistor 22 étant connecté au pôle négatif. Une diode 24 de protection est montée en inverse entre le collecteur et l'émetteur de chaque transistor 20,22. Le point milieu 26,28,30 agencé entre l'émetteur du transistor 20 et le collecteur du transistor 22 de chaque module 12,14,16 est relié à l'enroulement primaire d'un transformateur 32 triphasé. Le récepteur (non représenté) est alimenté par les conducteurs actifs L1,L2,L3,N raccordés l'enroulement secondaire du transformateur 32 avec interposition d'une cellule de condensateurs 34, et d'un disjoncteur 36 de protection.

Chaque module mutateur 12,14,16 comporte de plus un amplificateur 38 de puissance connecté aux bases des transistors 20,22. Le fonctionnement des différents modules 12,14,16 de l'onduleur 10 est piloté par une carte électronique 40 de commande, du type décrit dans les demandes de brevets français n 8612963 et 8612962 de la demanderesse.

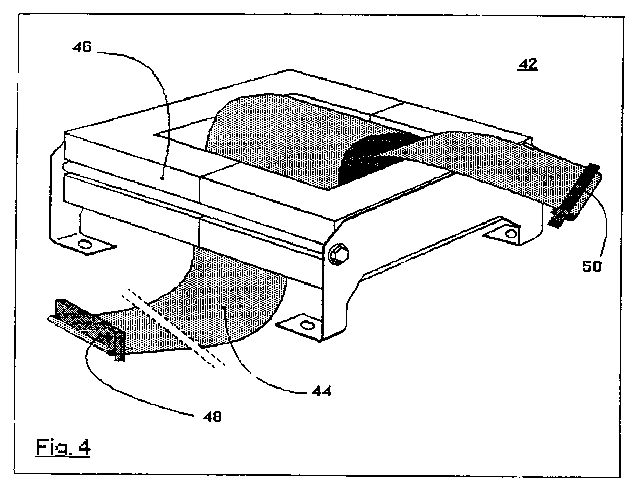

Dans la liaison électrique de la carte 40 avec les trois amplificateurs de puissance 38, est insérée une inductance 42 de mode commun, réalisée avec une limande 44 ou nappe de vingt six fils, enroulée sur le noyau central d'un circuit magnétique 46 unique de forme rectangulaire (figure 4). L'une des extrémités de la limande 44 est équipée d'un premier connecteur destiné à s'enficher dans un connecteur conjugué de la carte 40. L'autre extrémité porte un deuxième connecteur 50 auquel se raccordent trois torons de fils 52,54,56 reliés respectivement aux amplificateurs de puissance 38 des trois modules 12,14,16.

Les 26 fils de la limande 44 représentent la totalité des conducteurs relatifs aux commandes et aux informations de contrôle des six transistors de puissance 20,24 des modules 12,14,16. La partie intermédiaire de la limande 44 enroulée sur le circuit magnétique 46 forme la bobine de l'inductance 42, et la valeur de la réactance dépend du nombre de spires enroulées sur le circuit magnétique 46. A chaque puissance de l'onduleur 10 correspond une valeur prédéterminée de l'inductance 42 de filtrage pour obtenir une compensation optimum des perturbations de mode commun affectant les conducteurs de commande et de surveillance par suite des brusques variations de potentiel engendrées lors des phases de conduction et de blocage des transistors 20,22. Le circuit magnétique 46 est standard pour toutes les valeurs de l'inductance 42, seul change le nombre de spires de la limande 44 sur le noyau central. L'ncorporation de l'inductance 42 selon la figure 4 dans la liaison de la carte 40 avec les torons 52,54,56 s'effectue sans opération de soudage, la bobine de l'inductance 42 étant réalisée par l'enroulement de la limande 44 souple. Une seule inductance 42 de mode commun est suffisante pour la totalité des transistors 20,22 de l'onduleur 10 triphasé.

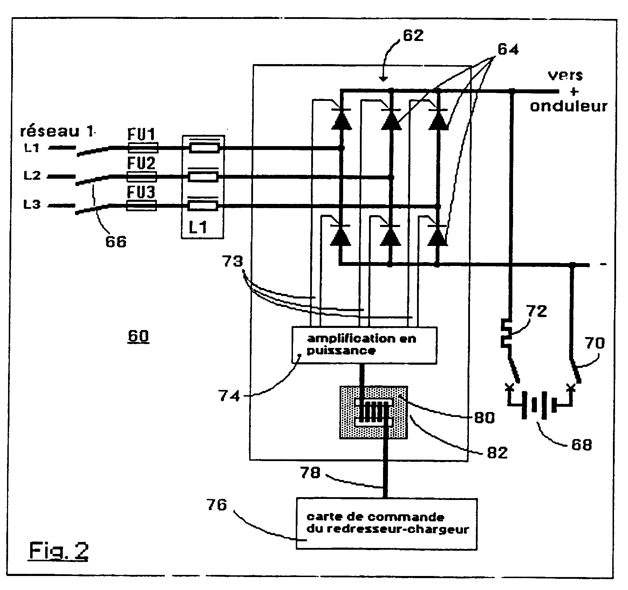

Selon la figure 2, un module redresseur/chargeur 60 comporte un pont de Graetz 62 triphasé équipé de six thyristors 64. L'entrée du pont 62 est raccordée au réseau alternatif à conducteurs actifs L1,L2,L3, par l'intermédiaire d'un interrupteur 66 et de fusibles FU1,FU2,FU3. La sortie du pont 62 est connectée à l'onduleur 10 de la figure 1, avec mise en parallèle d'un circuit à batterie 68 comprenant un interrupteur 70, et une résistance 72. Les gâchettes des thyristors 64 du pont 62 sont branchées électriquement par des conducteurs 73 à un amplificateur de puissance 74. Le réglage de l'angle d'amorçage des thyristors permettant d'ajuster la tension de sortie du pont 62 est assuré par une carte électronique de commande 76. La liaison électrique entre la carte 76 et l'amplificateur de puissance 74 est réalisée au moyen d'un toron 78 à fils 79 multiples, dont la partie intermédiaire est enroulée autour d'un circuit magnétique 80 pour former une inductance de mode commun 82.

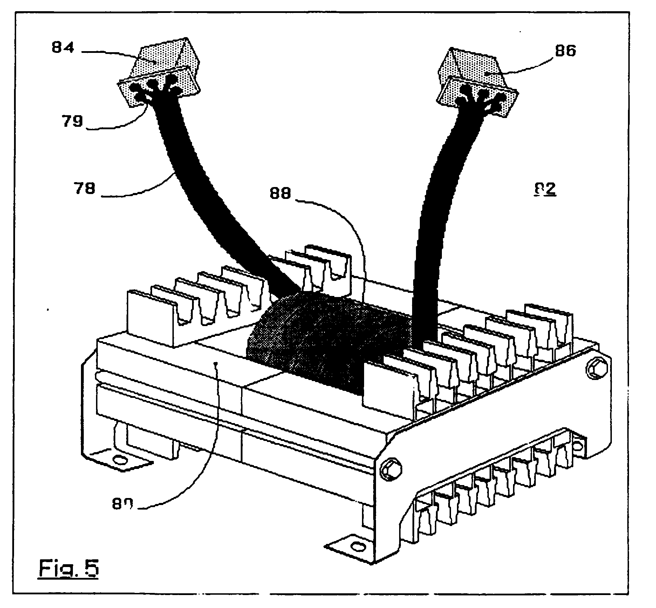

L'inductance de mode commun 82 est représentée sur la figure 5, et les différents fils 79 constitutifs du toron 78 sont raccordés par leurs extrémités opposées à deux connecteurs 84,86 destinés à être enfichés sur la carte 76 et le circuit imprimé de l'amplificateur 74. La bobine 88 de l'inductance 82 est formée par l'enroulement hélicoïdal du toron 78 sur la branche intérieure du circuit magnétique 80. On remarque que les liaisons de commande des thyristors 64 du module redresseur/chargeur 60 ont été regroupées dans un même toron, lui-même enroulé autour d'un circuit magnétique 80 commun pour constituer l'inductance de mode commun 82.

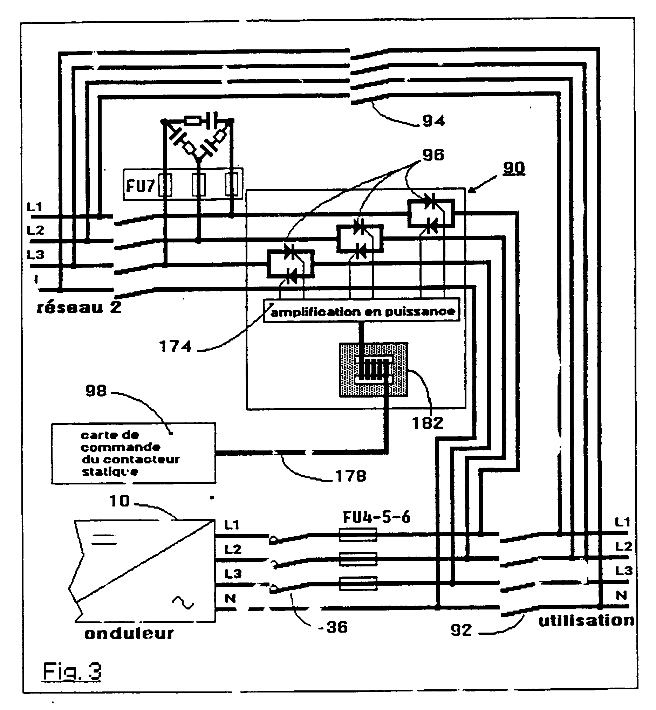

Selon la figure 3, un module contacteur statique 90 est inséré électriquement entre un deuxième réseau alternatif (réseau 2), et la sortie de l'onduleur 10. L'utilisation est raccordée aux sorties de l'onduleur 10 et du module contacteur statique 90 par l'intermédiaire d'un interrupteur 92. Un circuit dérivé (BY-PASS) avec disjoncteur 94 de mise en service, est branché directement en parallèle entre le réseau 2 et l'utilisation pour shunter le module contacteur statique 90.

Le module contacteur statique 90 comprend une paire de thyristors 96 en tête bêche, ou un triac dans chaque conducteur actif L1,L2,L3 du réseau 2. Les gâchettes des thyristors 96 sont reliées à un amplificateur de puissance 174 piloté par une carte électronique de commande 98. La carte 98 est raccordée à un amplificateur 174 par une liaison à toron 178 et une inductance de mode commun 182 du type illustré à la figure 5.

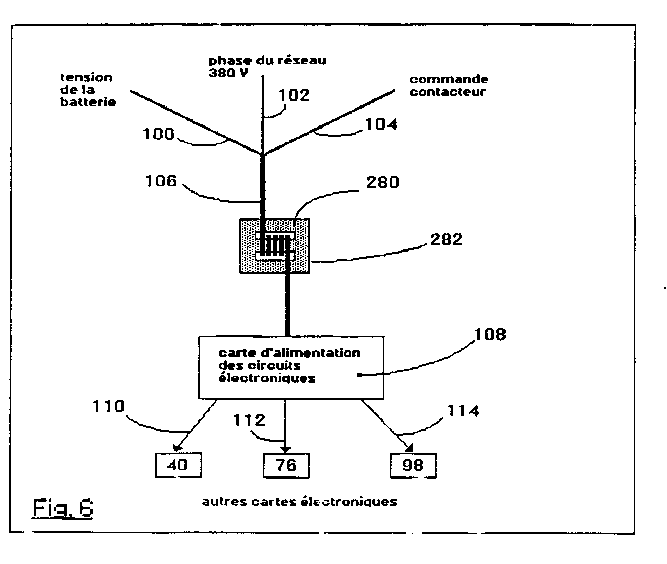

Sur la figure 6, tous les conducteurs 100,102,104 de puissance en provenance de la batterie 68, du réseau 380 V, et d'une commande contacteur à courant continu sont conformés, en un toron 106 unique de 6 fils, connecté électriquement à une carte d'alimentation 108, par exemple du type à découpage. La partie intermédiaire du toron 106 est bobinée sur un circuit magnétique 280 pour constituer une inductance de mode commun 282 du type illustré à la figure 5. L'inductance 282 se trouve incluse dans la fourniture d'énergie à la carte d'alimentation 108. Les conducteurs de puissance 110,112,114 à la sortie de la carte d'alimentation 108 ne véhiculent aucune perturbation de mode commun vers les autres cartes électroniques de commande 40,76,98.

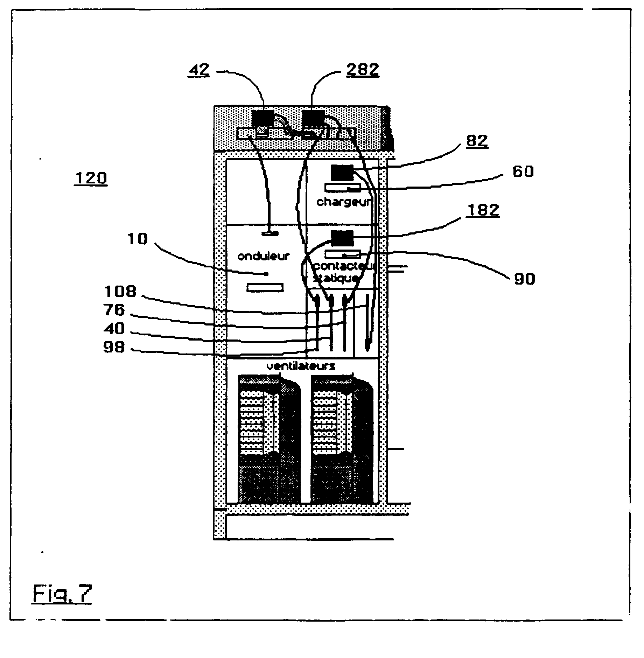

La figure 7 montre un exemple d'implantation des différentes inductances de mode commun 42,82,182,282 dans un système d'alimentation sans coupure 120 ayant des puissances comprises entre 10 et 20 k VA. L'architecture de l'alimentation sans coupure 120 est décrite en détail dans les demandes de brevets français n 8617709 et 8617710 de la demanderesse, et les inductances de mode commun 42,82,182,282 ont été disposées au voisinage des modules à semi-conducteurs de puissance et des cartes de commande correspondantes.

## Revendications

1. Convertisseur statique de puissance, notamment pour un système d'alimentation sans coupure, comprenant un circuit de conversion ayant une pluralité de semi-conducteurs de puissance (20, 22, 64, 96), une carte électronique (40, 76, 98) de commande des semi-conducteurs du circuit de conversion, et des moyens d'alimentation électrique (108) de la carte électronique de commande,
caractérisé en ce que la totalité des conducteurs de transmission d'informations de commande et de surveillance entre la carte de commande (40, 76, 98) et le circuit de conversion est conformée en limande (44) souple, dont la partie intermédiaire est enroulée sur un circuit magnétique (46, 80) unique pour constituer la bobine d'une inductance de mode commun (42, 82, 182), destinée à compenser les perturbations affectant la carte électronique, par l'action des variations de potentiel des semi-conducteurs engendrés lors du passage de l'état conducteur vers l'état bloqué, et vice-versa, que le circuit magnétique (46, 80) présente une structure rectangulaire ayant une noyau central sur lequel est enroulée la limande (44), et qu'un connecteur (48, 50, 84, 86) est connecté à chaque extrémité de la limande (44) pour faciliter l'insertion de l'inductance de mode commun entre la carte électronique et le circuit de puissance correspondant.

2. Convertisseur statique de puissance selon la revendication 1, caractérisé en ce que les semi-conducteurs de puissance du circuit de conversion comportent des transistors (20, 22) ou des thyristors (64, 96) ayant un couplage prédéterminé pour définir, soit des modules mutateurs (12, 14, 16) d'un onduleur (10), soit un module redresseur-chargeur (60), soit un module contacteur statique (90), ayant chacun respectivement une carte de commande (40, 76, 98) appropriée et une inductance de mode commun (42, 82, 182).

## Patentansprüche

1. Stromrichteranlage, insbesondere für ein unterbrechungsfreies Stromversorgungssystem, bestehend aus einer Stromrichterschaltung mit mehreren Leistungshalbleitern (20, 22, 64, 96), einer Elektronikkarte (40, 76, 98) zur Ansteuerung der Halbleiter der Stromrichterschaltung sowie einer Stromversorgungsschaltung (108) für die Elektronikkarte, dadurch gekennzeichnet, daß sämtliche Leiter zur Übertragung der Steuer- und Überwachungssignale zwischen der Elektronikkarte (40, 76, 98) und der Stromrichterschaltung als flexible Bandleitung (44) ausgebildet sind, deren Mittelteil auf einen einzigen Magnetkreis (46, 80) gewickelt ist, um so eine gemeinsame Drosselspule (42, 82, 182) zur Ausgleichung der die Elektronikkarte beeinflussenden Störsignale zu bilden, die durch Spannungsänderungen an den Halbleitern beim Umschalten von Durchlaß- in Sperrbetrieb bzw. umgekehrt auftreten und auf die Elektronikkarte wirken. dass der Magnetkreis (46, 80) eine rechteckige Struktur aufweist, mit einem zentralen Kern, auf dem die Bandleitung (44) aufgerollt ist, und dass ein Steckverbinder (48, 50, 84, 86) mit jedem Ende der Bandleitung (44) verbunden ist, um die Einfügung der Drosselspule zwischen die Elektronikkarte und dem entsprechenden Leistungskreis zu erleichtern.

2. Stromrichteranlage nach Anspruch 1, dadurch gekennzeichnet, daß die Leistungshalbleiter der Stromrichterschaltung aus Transistoren (20, 22) oder Thyristoren (64, 96) bestehen, die in geeigneter Weise zusammengeschaltet sind, um als Steuerventile (12, 14, 16) eines Wechselrichters, als Gleichrichter-Ladegerät (60) oder als elektronischer Netzumschalter (90) zu arbeiten, die jeweils mit einer geeigneten Elektronikkarte (40, 76, 98) sowie einer Drosselspule (42, 82, 182) zur Unterdrückung von Gleichtakt-Störsignalen ausgerüstet sind.

## Claims

1. A static power converter, notably for an uninterruptible power supply system, comprising a conversion circuit having a plurality of power semi-conductors (20,22,64,96), an electronic control board (40,76,98) of the conversion circuit semi-conductors, and means (108), of supplying electrical power to the control board,
characterized in that all the control and monitoring data transmission conductors between the control board (40,76,98) and the conversion circuit are formed into a flexible flat cable (44) whose intermediate part is wound onto a single magnetic circuit (46,80) to constitute a common mode inductance (42,82,182) designed to compensate the disturbances affecting the printed circuit board due to the potential changes of the semi-conductors generated when switching takes place from the conducting state to the blocked state, and vice-versa, in that the magnetic circuit (46,80) comprises a rectangular structure with a centre core onto which is wound the flat cable (44), and that a connector (48,50,84,86) is connected to each end of the flat cable (44) to facilitate the insertion of the common mode inductance between the printed circuit board and the corresponding power circuit.

2. The static power converter according to claim 1, characterized in that the conversion circuit power semi-conductors comprise transistors (20, 22) or thyristors (64,96) having a predetermined coupling to define either stack modules (12,14,16) of an inventer (10) or a rectifier-charger module (60), or a static switch module (90), each respectively having an appropriate control board (40,76,98) and a common mode inductance (40,82,182).
